# EUROPEAN PATENT APPLICATION

(11) **EP 3 133 646 A2**
(43) Date of publication of application: **22.02.2017**
(21) Application number: 16180779.7
(22) Date of filing: 22.07.2016
(51) Int. Cl.: H01L 27/146

(54) **SENSOR ASSEMBLY WITH SELECTIVE INFRARED FILTER ARRAY**

(30) Priority: 31.07.2015 US 201562199928 P; 28.12.2015 US 201514981539
(71) Applicant: Dual Aperture International Co. Ltd, Gyeonggi-Do (KR)
(72) Inventor: Kyong, Chong-Min, Gyeonggi-Do (KR); Choi, Sang Gil, Gyeonggi-Do (KR); Mun, Junho, Gyeonggi-Do (KR); Woo, Taekun, Gyeonggi-Do (KR); Wajs, Andres Augustine, Gyeonggi-Do (KR); Lee, David D., Gyeonggi-Do (KR)
(74) Representative: Awapatent AB

(57) **Abstract**

An image sensor (270) includes both visible pixels (130R, 130G, 130B) and infrared pixels (130I). The visible pixels produce signals indicative of light within a visible band received by the visible pixels, and the infrared pixels produce signals indicative of light within an infrared band received by the infrared pixels. A selective infrared (SIR) filter array is integrated on the image sensor. The SIR filter array (260) includes SIR pixel filters that are positioned to filter out light within the infrared band propagating to the visible pixels. In this way, infrared crosstalk to the visible pixels can be reduced.

## Description

### CROSS-REFERENCE TO RELATED APPLICATION(S)

This application claims priority under 35 U.S.C. § 119(e) to U.S. Provisional Patent Application Serial No. 62/199,928, "Dual-band Camera" filed Jul 31, 2015. The subject matter of all of the foregoing is incorporated herein by reference in its entirety.

### BACKGROUND

### 1. Field of the Invention

This disclosure relates generally to image sensors, and more particularly, to image sensors with selective infrared (SIR) filters, for example to reduce infrared leakage into visible pixels.

### 2. Description of Related Art

Image sensors have been widely used in digital cameras, mobile devices, security systems, computers, and many other applications. Some image sensors are designed to capture both visible (e.g., color) and infrared light. For example, some of the pixels in an image sensor may be used to convert visible light into electronic signals indicating color image information, and other pixels may be used to convert infrared light to electronic signals indicating infrared image information. The different images may be combined for various purposes. However, because the visible pixels and infrared pixels are spatially multiplexed on an image sensor, there can be strong spectral crosstalk especially of infrared light onto the visible pixels.

In one approach, image post-processing techniques have been used to reduce the spectral crosstalk. For example, the infrared crosstalk in the visible signal may be estimated somehow, and then subtracted. Ideally, what remains would represent the contributions from only the visible light since the contributions from the infrared light presumably have been removed. However, these techniques are limited because it can be difficult to accurately estimate the amount of infrared crosstalk. In addition, because the visible pixel initially captures the sum of the infrared and visible light, less than the full dynamic range of the visible pixel is available for the visible light alone. This can reduce the dynamic range and signal to noise ratio (SNR) of the post-processed signal, among other effects.

Therefore, there is a need for better approaches to reduce the spectral crosstalk.

### SUMMARY

The present disclosure overcomes the limitations of the prior art by integrating a selective infrared (SIR) filter array with an image sensor.

In one aspect, an image sensor includes both visible pixels and infrared pixels. The visible pixels produce signals indicative of light within a visible band received by the visible pixels, and the infrared pixels produce signals indicative of light within an infrared band received by the infrared pixels. An SIR filter array is integrated on the image sensor. The SIR filter array includes SIR pixel filters that are positioned to filter out light within the infrared band propagating to the visible pixels. In this way, infrared crosstalk to the visible pixels can be reduced. In some embodiments, the SIR filter array filters out light in the 650-800 nm band and/or filters out light around 850 nm +/- 50 nm. Such materials are available from Fuji Film Electronic Materials, for example.

Other aspects include components, devices, systems, improvements, methods, processes, applications, computer readable mediums, and other technologies related to any of the above.

### BRIEF DESCRIPTION OF THE DRAWINGS

Embodiments of the disclosure have other advantages and features which will be more readily apparent from the following detailed description and the appended claims, when taken in conjunction with the accompanying drawings, in which:
FIG. 1A is a block diagram of a multi-aperture, shared sensor imaging system using a sensor assembly according to one embodiment of the invention.
FIG. 1B illustrates an example of a filter design of a sensor assembly for capturing both visible and infrared light in the shared sensor imaging system of FIG. 1A.
FIG. 2A is a cross-sectional diagram of a shared sensor imaging system using an SIR filter array, according to one embodiment of the invention.
FIG. 2B is a cross-sectional view of a sensor assembly suitable for use in the shared sensor imaging system of FIG. 2A.
FIG. 2C illustrates spectral responses of light captured by visible pixels of the shared sensor imaging system of FIG. 2A.
FIG. 2D illustrates spectral responses of light captured by infrared pixels of the shared sensor imaging system of FIG. 2A.
FIG. 2E is a plan view of a block structure for a sensor assembly suitable for use in the shared sensor imaging system of FIG. 2A.
FIG. 3A is a cross-sectional diagram of a shared sensor imaging system using a longer wavelength infrared cutoff filter, according to one embodiment of the invention.
FIG. 3B illustrates spectral responses of light captured by visible pixels of the shared sensor imaging system of FIG. 3A.
FIG. 3C illustrates spectral responses of light captured by infrared pixels of the shared sensor imaging system of FIG. 3A.
FIGS. 4A-4C depict operation of a multi-aperture imaging system according to one embodiment of the invention.
FIG. 5A is a cross-sectional diagram of a shared sensor imaging system using a multi-band filter, according to another embodiment of the invention.
FIG. 5B is a diagram of one embodiment of the multi-band filter of FIG. 5A.
FIG. 5C illustrates spectral responses of light captured by visible pixels of the shared sensor imaging system of FIG. 5A.
FIG. 5D illustrates spectral responses of light captured by infrared pixels of the shared sensor imaging system of FIG. 5A.
FIG. 6 is a cross-sectional diagram of another shared sensor imaging system using a multi-band filter, according to one embodiment of the invention.
FIG. 7 is a cross-sectional diagram of an imaging system for capturing visible and infrared light, according to one embodiment of the invention.

The figures depict various embodiments for purposes of illustration only. One skilled in the art will readily recognize from the following discussion that alternative embodiments of the structures and methods illustrated herein may be employed without departing from the principles described herein.

### DETAILED DESCRIPTION OF THE PREFERRED EMBODIMENTS

The figures and the following description relate to preferred embodiments by way of illustration only. It should be noted that from the following discussion, alternative embodiments of the structures and methods disclosed herein will be readily recognized as viable alternatives that may be employed without departing from the principles of what is claimed.

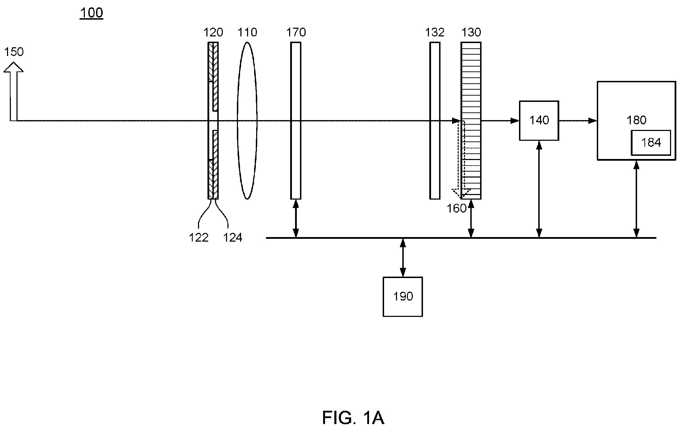

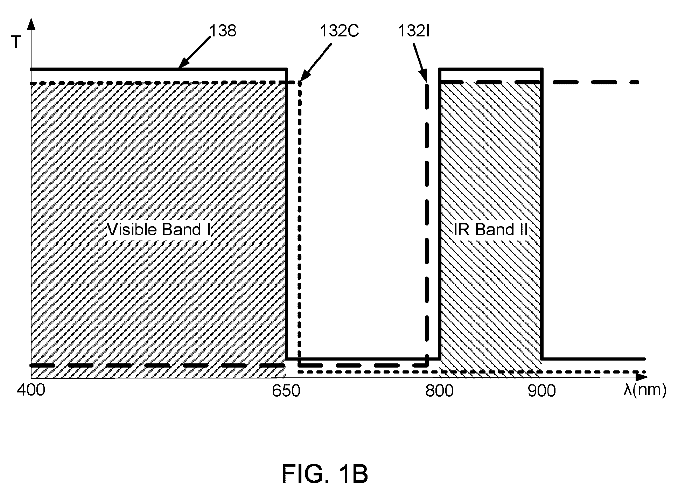

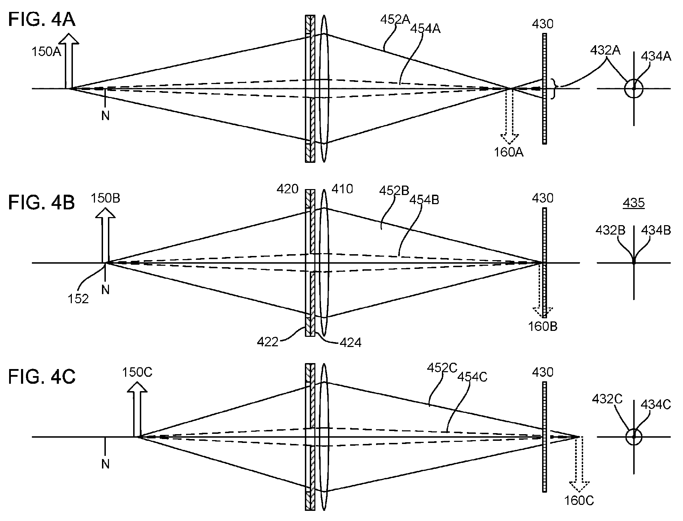

FIG. 1A is a block diagram of a multi-aperture, shared sensor imaging system using a sensor assembly according to one embodiment of the invention. The imaging system may be part of a digital camera or integrated in a mobile phone, a webcam, a biometric sensor, image scanner or any other multimedia device requiring image-capturing functionality. The system depicted in FIG. 1 includes imaging optics 110 (e.g., a lens and/or mirror system), a multi-aperture system 120 and an image sensor 130. The imaging optics 110 images objects 150 from a scene onto the image sensor 130. In FIG. 1, the object 150 is in focus, so that the corresponding image 160 is located at the plane of the image sensor 130. As described in FIG. 4, this will not always be the case. Objects that are located at other depths will be out of focus at the image sensor 130.

The multi-aperture system 120 includes at least two apertures, shown in FIG. 1 as apertures 122 and 124. In this example, aperture 122 is the aperture that limits the propagation of visible light, and aperture 124 limits the propagation of infrared light. In this example, the two apertures 122, 124 are placed together but they could also be separated. This type of multi-aperture system 120 may be implemented by wavelength-selective optical components, such as wavelength filters. For convenience, wavelength filters that are used to implement the apertures will be referred to as aperture filters. Examples of different types of aperture filters are described in the figures below. As used in this disclosure, terms such as "light" "optics" and "optical" are not meant to be limited to the visible part of the electromagnetic spectrum but to also include other parts of the electromagnetic spectrum where imaging may occur, including infrared.

The image sensor 130 detects both the visible image corresponding to aperture 122 and the infrared image corresponding to aperture 124. In effect, there are two imaging systems that share a single sensor array 130: a visible imaging system using optics 110, aperture 122 and image sensor 130; and an infrared imaging system using optics 110, aperture 124 and image sensor 130. The imaging optics 110 in this example is fully shared by the two imaging systems, but this is not required. In addition, the two imaging systems do not have to be visible and infrared. They could be other spectral combinations: red and green, or infrared and white (i.e., visible but without color), for example.

The exposure of the image sensor 130 to electromagnetic radiation is typically controlled by a shutter 170 and the apertures of the multi-aperture system 120. When the shutter 170 is opened, the aperture system controls the amount of light and the degree of collimation of the light exposing the image sensor 130. The shutter 170 may be a mechanical shutter or, alternatively, the shutter may be an electronic shutter integrated in the image sensor. The image sensor 130 typically includes rows and columns of photosensitive sites (pixels) forming a two dimensional pixel array. The image sensor may be a CMOS (complimentary metal oxide semiconductor) active pixel sensor or a CCD (charge coupled device) image sensor. Alternatively, the image sensor may relate to other Si (e.g. a-Si), III-V (e.g. GaAs) or conductive polymer based image sensor structures.
When the light is projected by the imaging optics 110 onto the image sensor 130, each pixel produces an electrical signal, which is indicative of the electromagnetic radiation (energy) incident on that pixel. In order to separate the different spectral components of an image which is projected onto the imaging plane of the image sensor 130, typically a spectral filter array(s) 132 is interposed between the imaging optics 110 and the image sensor 130. The spectral filter arrays 132 may be integrated with the image sensor 130 to form a sensor assembly, such that each pixel of the image sensor has a corresponding pixel filter. Each spectral filter is adapted to pass light of a predetermined wavelength band onto the pixel. Usually a combination of red, green and blue (RGB) filters plus an infrared (I) filter are used. However other filter schemes are also possible, e.g. CYGMI (cyan, yellow, green, magenta, infrared), RGBEI (red, green, blue, emerald, infrared), etc. Alternately, the image sensor may have a stacked design where red, green and blue sensor elements are stacked on top of each other rather than relying on individual pixel filters. The infrared sensor elements could be part of the stack to form an RGBI stack, or could be implemented separately from the RGB stack.

Each pixel of the exposed image sensor 130 produces an electrical signal proportional to the electromagnetic radiation passed through the spectral filter arrays 132 associated with the pixel. The array of pixels thus generates image data (a frame) representing the spatial distribution of the electromagnetic energy (radiation) passed through the spectral filter arrays 132. The signals received from the pixels may be amplified using one or more on-chip amplifiers. In one embodiment, each spectral channel of the image sensor may be amplified using a separate amplifier, thereby allowing to separately control the ISO speed for different wavelength bands.

Further, pixel signals may be sampled, quantized and transformed into words of a digital format using one or more analog to digital (A/D) converters 140, which may be integrated on the chip of the image sensor 130. The digitized image data are processed by a processor 180, such as a digital signal processor (DSP) coupled to the image sensor, which is configured to perform well known signal processing functions such as interpolation, filtering, white balance, brightness correction, and/or data compression techniques (e.g. MPEG or JPEG type techniques).

The processor 180 may include signal processing functions 184 for obtaining depth information associated with an image captured by the multi-aperture imaging system 100. These signal processing functions may provide a multi-aperture imaging system 100 with extended imaging functionality including variable depth of focus, focus control and stereoscopic 3D image viewing capabilities.

The processor 180 may also be coupled to additional compute resources, such as additional processors, storage memory for storing captured images and program memory for storing software programs. A controller 190 may also be used to control and coordinate operation of the components in imaging system 100. Functions described as performed by the processor 180 may instead be allocated among the processor 180, the controller 190 and additional compute resources.

FIG. 1B illustrates one example of a filter design of a sensor assembly for capturing both visible and infrared light, as may be used in the shared sensor imaging system of FIG. 1A. In the design of FIG. 1B, the color pixels within the sensor assembly receive light within a visible band I, which is wavelengths up to approximately 650nm. The sensor assembly typically has additional color pixel filters (e.g., R,G,B color pixel filters), not shown in FIG. 1B, which subdivide the visible band I into individual color elements. The infrared pixels within the sensor assembly receive light within an infrared band II, which in this example is a wavelength range of approximately 800-900 nm. In this example, the visible band I and infrared band II are separated by a buffer band of approximately 650-800 nm.

FIG. 1B shows ideal spectral responses of a multi-band filter 138, a visible filter array 132C, and an infrared filter array 1321. The multi-band filter 138 represents the net effect of wavelength filtering by components outside the sensor assembly. For example, it may be implemented as a single wavelength filter with two pass bands as shown. Alternately, it could be implemented as multiple components, for example one wavelength filter that cuts out wavelengths longer than 900 nm plus a second wavelength filter that cuts outs the band between 650-800 nm. Both the visible band I and the infrared band II are passed by the multi-band filter 138.

However, visible pixels on the sensor assembly should detect only visible light and not infrared light. The color filter array 132C filters out infrared light propagating towards the visible pixels. In most designs, there will not be a single type of visible pixel filter. Rather, there will be multiple types of color pixel filters (e.g., R,G,B pixel filters) so the spectral response 132C shown in FIG. 1B is meant to be representative of the aggregate response of these different types. Similarly, infrared pixels on the sensor assembly should detect only infrared light and not visible light. The infrared filter array 1321 filters out visible light propagating towards the infrared pixels.

Note that the visible band I is determined by the aggregate effect of the multi-band filter 138 and the color filter array 132C. In FIG. 1B, the cutoff wavelength of 650 nm for the multi-band filter 138 is shorter than that of the color filter array 132C, so the multi-band filter 138 determines the long wavelength boundary for visible band I. In fact, the cutoff wavelength for the color filter array 132C could occur anywhere between 650-800 nm, so long as the color filter array 132C still filters out the IR band II. Alternately, the color filter array 132C could have the shorter cutoff wavelength, or both filters could act in tandem to determine the effective cutoff wavelength. In addition, the color filter array 132C could also pass infrared wavelengths so long as they are longer than 900 nm, because the multi-band filter 138 filters out these longer wavelengths. Similar remarks apply to the multi-band filter 138 and IR filter array 1321, with respect to the IR band II.

As will be seen from the examples below, the specific wavelengths shown in FIG. 1B are not required. The visible band I and infrared band II can occupy different wavelength bands than the ones shown. In some designs, the visible band I and infrared band II can be contiguous or even overlapping. Most wavelength components will not have the ideal performance shown in FIG. 1B, so some mixing between the bands is to be expected.

In FIG. 1A, the color filter array 132C and infrared filter array 1321 are part of the spectral filter arrays 132. FIG. 1A also provides a multi-aperture system 120 to define different size apertures for the two bands I and II. In this example, the color band I provides the image from larger aperture 122 and infrared band II provides the image from smaller aperture 124. Thus, the multi-aperture system 120 can be implemented as a wavelength component that cuts out infrared band II for the region outside the smaller aperture 124. The two images are compared to estimate depth information.

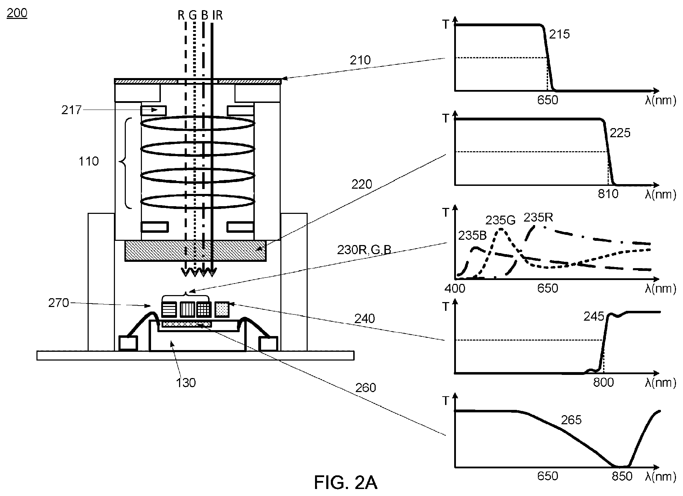

FIGS. 2A-2E illustrate a shared sensor imaging system 200 using an SIR filter array 260, according to one embodiment of the invention. FIG. 2A is a cross-sectional diagram of the shared sensor imaging system 200. The system includes imaging optics 110, an aperture filter 210, a mechanical aperture 217, an infrared cut-off filter 220 with a cutoff of 810nm (cut-off can be defined as the wavelength at which the transmission decreases to 50% of maximum value), and a sensor assembly 270. The sensor assembly 270 includes a black filter array 240, a red color filter array 230R, a green color filter array 230G, a blue color filter array 230B, an SIR filter array 260, and an image sensor 130 with an array of light-sensitive pixels.

The system 200 operates as an imaging system with a first aperture for light within a visible band and operates as an imaging system with a different second aperture for light within an infrared band. The visible aperture typically is larger than the infrared aperture. This dual aperture structure is implemented by the aperture filter 210. The aperture filter 210 is a multi-zone wavelength filter. That is, it has multiple zones with different wavelength responses. In FIG. 2A, multi-zone wavelength filter has a central zone which is shown as clear in FIG. 2A and an outer annular zone which is cross-hatched in FIG. 2A. The central zone passes light of all wavelengths. The outer zone has the spectral response 215. It is a shortpass filter that transmits visible light up to approximately 650nm and filters out wavelengths above 650nm.

In this embodiment, the aperture filter 210 is a glass disk coated with infrared blocking material in the outer zone. The center zone is uncoated or it could be a physical hole. The aperture filter 210 may be manufactured by multi-layer coating technique with a small-diameter masked center for the clear coating. In one example, the aperture filter 210 may be manufactured by utilizing the interference nature of light waves via depositing materials of varying indices, e.g., depositing alternately materials with high (e.g., TiO₂, Titanium dioxide) and low refractive index (e.g., SiO₂, Silicon dioxide).

Light passing through the aperture filter 210 is delivered by the imaging optics 110 to the sensor assembly 270. The light is physically limited by the mechanical aperture 217, which sets the size of the visible aperture. It is also filtered by the 810nm infrared cut-off filter 220, with spectral response 225. It is a shortpass filter that transmits visible and infrared light up to approximately 810nm and filters out wavelengths above 810nm.

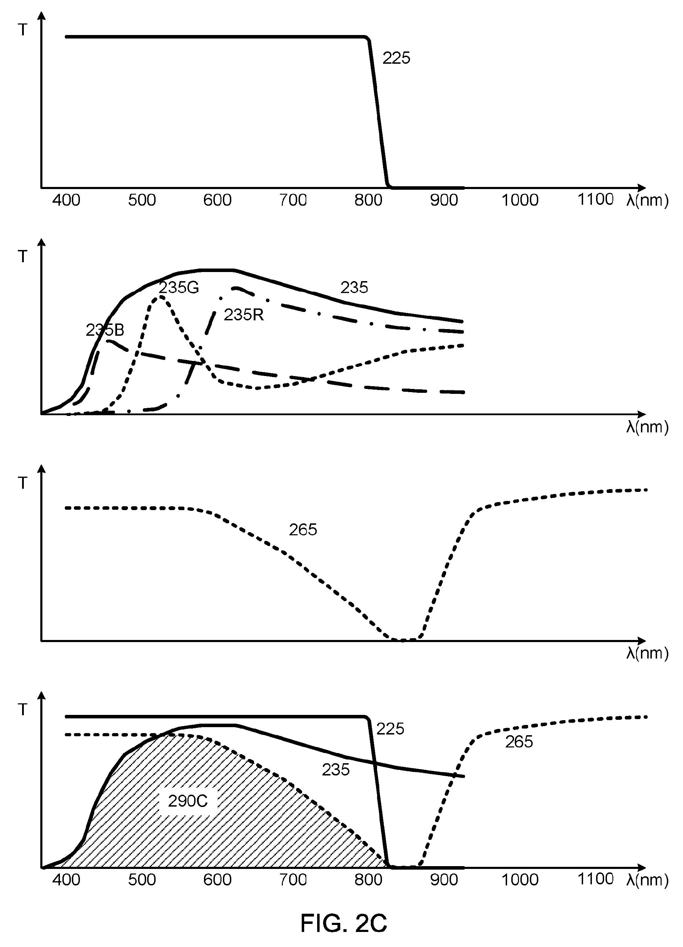

The sensor assembly 270 also contains some integrated filters: red color filter array 230R, green color filter array 230G, blue color filter array 230B, SIR filter array 260, and black filter array 240. Corresponding spectral responses are shown by curves 235R, 235G, 235B, 265 and 245, respectively. For the color pixels, the red pixel filter 230R, the green pixel filter 230G, and the blue pixel filter 230B provide the corresponding color responses for the visible pixels in the image sensor 130. The SIR filter array 260 filters out infrared light that otherwise would be transmitted to the visible pixels in the image sensor 130, as will be explained in FIG. 2C. The black filter array 240 is a longpass filter with cut-on wavelength of approximately 800nm, where the transmission increases to 50% of maximum value.

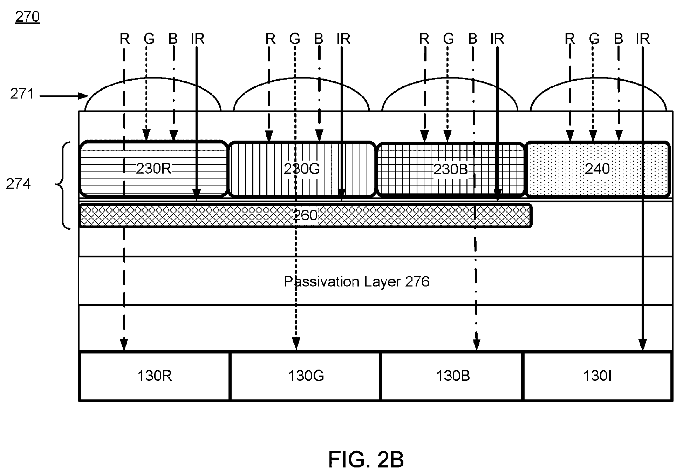

FIG. 2B is a cross-sectional view of a sensor assembly suitable for use in the shared sensor imaging system of FIG. 2A. The sensor assembly 270 is fabricated using CMOS fabrication techniques. From bottom to top, the sensor assembly 270 includes an array of photodiodes 130 (i.e., the image sensor pixels), a passivation layer 276, infrared/color filter array (ICFA) 274, and a microlens array 271. The sensor assembly also includes other circuitry and interconnects, which are not shown for clarity. The photodiodes 130 embedded in the silicon substrate convert light into electronic signals. The passivation layer 276 is on top of the active circuitry for insulation. The ICFA includes a RGB filter array 230, a SIR filter array 260, and a black filter array 240. The ICFA is on top of the passivation layer 276 and is located below the microlens array 271. The microlens array 271 focuses light onto the photodiodes 130, filtered by the ICFA. Each microlens may be associated with one photodiode.

The SIR filter array 260 includes SIR pixel filters positioned to filter out infrared crosstalk propagating to visible pixels. The SIR pixel filters 260 may be located between the color pixel filters 230 and the color pixels 130, as shown in FIG. 2B. In one embodiment, the SIR pixel filter is made of material available from Fuji Film Electronic Materials.

The black filter array 240 includes black pixel filters positioned to filter out visible crosstalk propagating to the infrared pixels. The black pixel filter is made of filter materials having a high transmittance for wavelengths in the infrared band of the spectrum. In one embodiment, the black filter can be made from material supplied by Fuji Film Electronic Materials. In another embodiment, the black filter is made of a black polyimide material sold by Brewer Science under the trademark "DARC 400". These black filters have different cutoff wavelengths. The black filter shown in FIG. 2A has a cutoff wavelength of approximately 800 nm.

Fitler arrays are described in more detail in US2009/0159799, "Color infrared light sensor, camera and method for capturing images," which is incorporated herein by reference.

As shown in FIG.2B, the filter arrays may receive both visible and infrared light. The red filter array 230R has spectral response 235R (shown in FIGS. 2A,C) and transmits both red and infrared light. The SIR filter array 260 filters out the infrared light and allows only red light to reaching the underlying photodiode. Similar processes occur for the green filter array 230G and the blue filter array 230B.

FIG. 2C illustrates the overall spectral response 290C for the multi-aperture imaging system 200, for light captured by visible pixels 130R,G,B of the image sensor. Referring to FIG. 2A, light captured by a visible pixel 130 passes through the aperture filter 210, infrared cut-off filter 220, one of the color filter arrays 230R,G,B, and the SIR filter array 260. Ignore the aperture filter 210 for now. FIG. 2C shows the spectral responses of all of the other filters. As can be seen, the spectral responses for the three color pixel filters 230R,G,B extend into the infrared range. In particular, the spectral response 235R shows that the red pixel filter 230R transmits strong infrared light that results in strong spectral crosstalk from infrared leakage to the red color pixel 130R. This can have a significant effect, since the sensitivity of the image sensor 130 to infrared radiation is approximately four times higher than its sensitivity to visible light. The spectral crosstalk can affect image quality (e.g., color correction, color reproduction, noise), dynamic range, and accuracy of depth estimation.

The SIR pixel filter 260 significantly reduces the spectral crosstalk. The graph 265 shows the spectral response of the SIR pixel filters 260, which roughly has two passbands separated by a stop band. The first passband includes the visible and then rolls off from 90% transmittance at 650nm to zero transmittance at approximately 800-850nm. The second passband transmits light starting approximately from 850-900nm. The graph 290C overlays the spectral responses for the infrared cut-off filter 225, the color filter arrays 235 (represented by an aggregate curve representing the general spectral behavior of the three-color pixel filters), and the SIR filter array 265. The aggregate color response 290C shown by the hashed region is not the calculated actual response, which would require multiplying together the component spectral responses. Rather, the hashed region is merely intended to indicate the general spectral behavior of the system. In particular, compared with spectral response 235, the infrared light in the aggregate color response 290C is significantly reduced by the SIR pixel filter, which in turn decreases the spectral crosstalk for the visible pixels 130R,G,B.

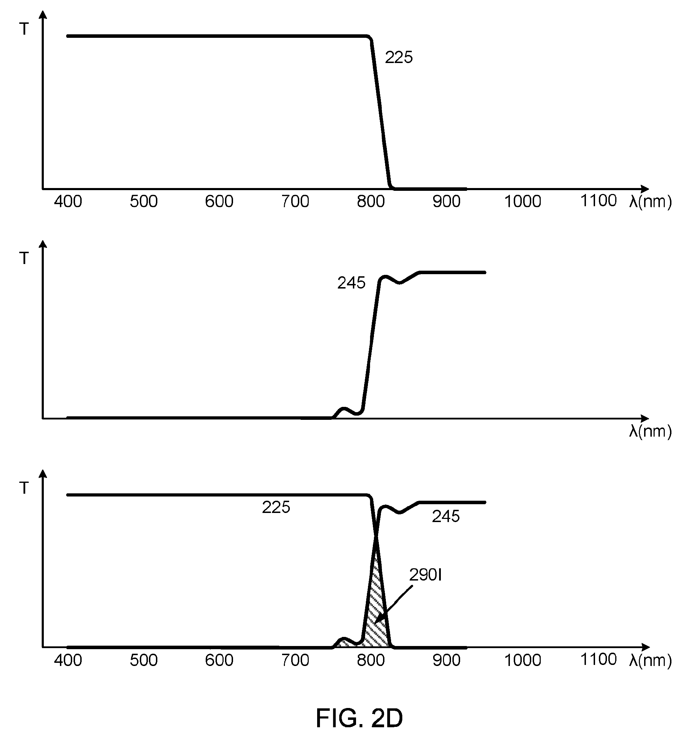

Referring to FIG. 2B, for the infrared pixel 1301, the black filter array 240 filters out the visible light and transmits the infrared light to the passivation layer 276. FIG. 2D illustrates the overall spectral response 2901 for the multi-aperture imaging system 200, for light captured by the infrared pixels 1301 of the image sensor. FIG. 2D is set up the same way as FIG. 2C. Spectral responses 225 and 235 are for the filter elements encountered by light propagating to the infrared pixel 1301. The aggregate infrared response 2901 is shown in the bottom graph. As with FIG. 2C, the hashed region shows the overlap between the major spectral contributors and is merely intended to indicate the general spectral behavior of the system. The infrared pixel 1301 received infrared light from the wavelength band of approximately 750nm-810nm.

FIGS. 2C and 2D ignored the effect of the aperture filter 210, which is an all-pass filter in the center zone and a shortpass filter with cut-off wavelength of approximately 650nm in the outer zone. For light coming through the center zone, the aperture filter 210 will have no effect on the spectral responses shown in FIGS. 2C and 2D. That is, light propagating to the color pixels 130R,G,B will still experience the spectral filtering shown in FIG. 2C and light propagating to the infrared pixel 1301 will still experience the spectral filtering shown in FIG. 2D. For light coming through the outer zone. The aperture filter 210 will effectively filter out wavelengths above 650nm. This will effectively block transmission to the infrared pixel 1301, as desired, and will further reduce the infrared crosstalk to the color pixels 130R,G,B.

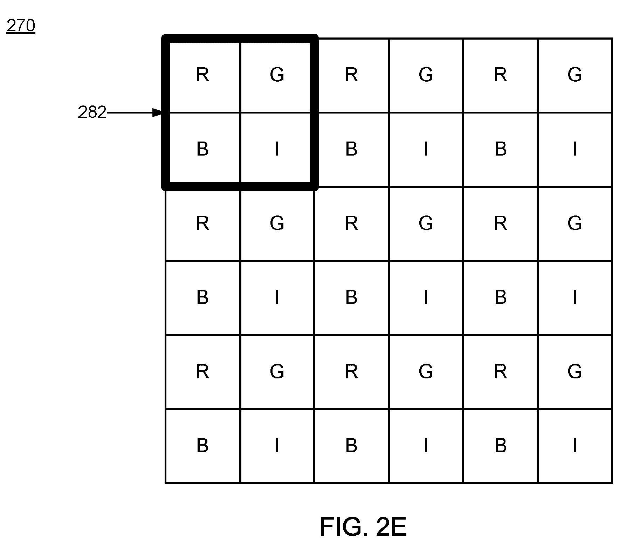

In FIGS. 2A-2B, the pixels 130 are shown in a linear array. This is not required. For example, FIG. 2E is a plan view of a block structure 282 in a sensor assembly 270 according to one embodiment of the invention. The sensor assembly 270 has blocks of pixels, e.g. a block 282 of 2×2 pixels, where each block includes a red, green, blue and infrared (RGBI) pixel. Such configuration of the sensor assembly is described in more detail in US2009/0159799, "Color infrared light sensor, camera and method for capturing images," which is incorporated herein by reference. Typical pixel sizes range from 0.8 to 2µm and typically are not larger than 4µm.

The number of pixels in the sensor assembly 270 depends on the size of the second aperture and the number of pixels in the block. The sensor assembly 270 typically includes 2-16 million RGBI pixels arranged in a rectangular array with a pixel to pixel spacing not greater than 4µm. Typically, the size of the sensor assembly 270 is 1/4 inch or greater. The sensor assembly 270 generates visible and infrared signals for forming a raw mosaic image. A demosaicking processing can be used to reconstruct a full-resolution color image from the mosaic color image.

In the example of FIGS. 2A-2D, the infrared cut-off filter 220 had a cut-off wavelength of approximately 810nm. However, because the SIR filter array 260 filters out infrared light to the visible pixels, the cut-off wavelength of the infrared cut-off filter can be extended to a longer wavelength.

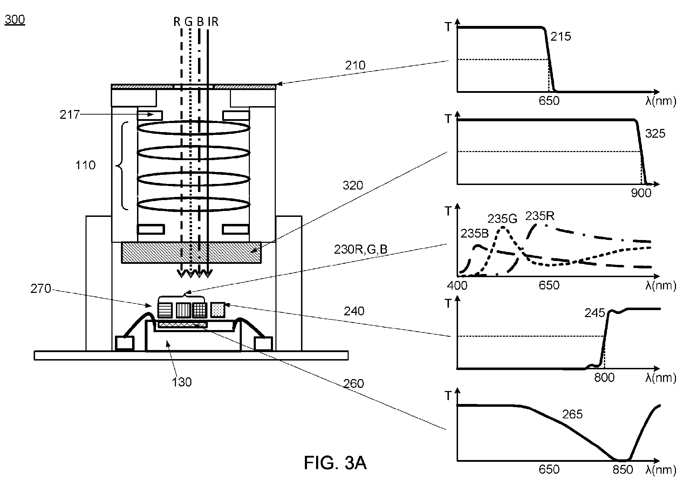

FIGS. 3A-3C illustrate such an example. FIG. 3A is a cross-sectional diagram of a shared sensor imaging system 300 using a longer wavelength infrared cutoff filter 320, which has a cut-off wavelength of approximately 900nm, instead of 810nm. The infrared cut-off filter 320 is a shortpass filter that transmits both visible and infrared light with wavelengths up to approximately 900nm. FIG. 3A also shows the spectral response 325 of this filter 320. Otherwise, the system 300 is the same as system 200. The longer cut-off wavelength may be determined by the spectral response 265 of the SIR pixel filter. For example, it may be chosen as the wavelength at which the spectral response 265 increases to a certain threshold.

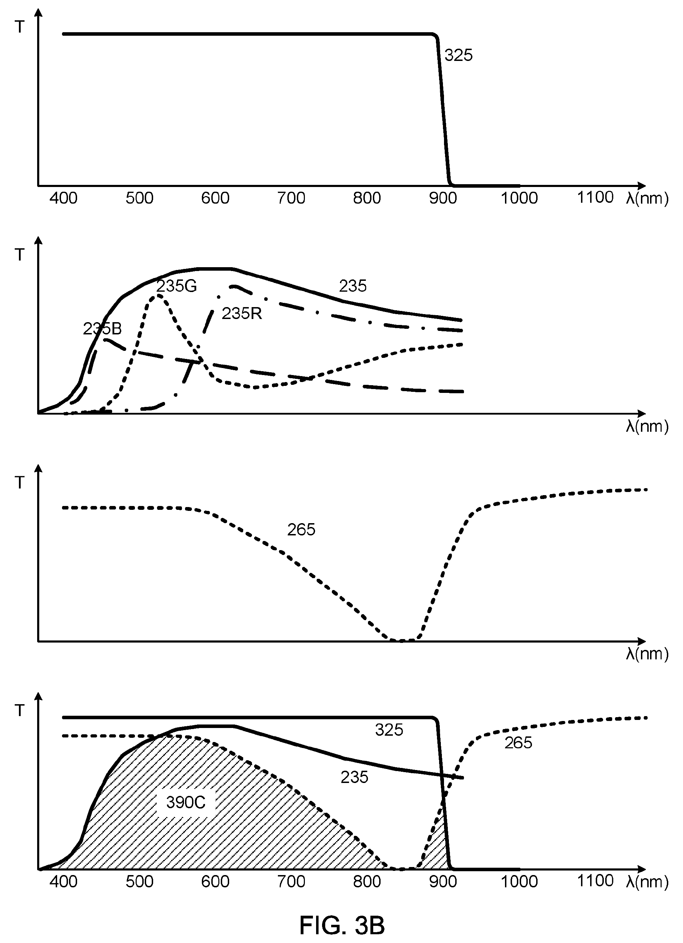

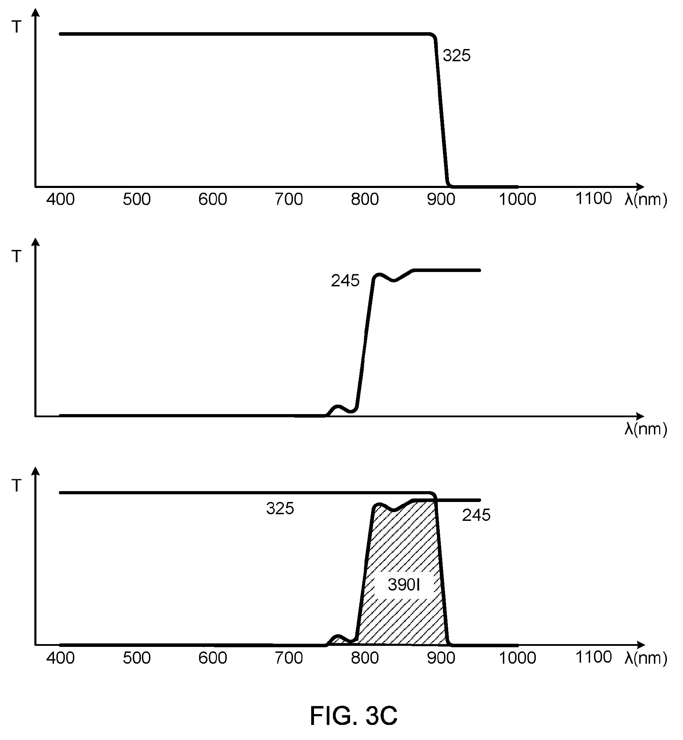

FIGS. 3B and 3C show the system's spectral responses. They are the same as FIGS. 2C and 2D, except the spectral response 225 is replaced by spectral response 325. For FIG. 3B compared to FIG. 2C, a little more amount of the infrared light with wavelength from 850nm to 900nm is transmitted by the aggregate color response 390C. However, this additional infrared crosstalk is still much less than when only the color pixel filters (curve 235) are used. For FIG. 3C compared to FIG. 2D, the aggregate response 3901 shows that much more infrared light is received by the infrared pixels 1301.

By utilizing the SIR filter 260, the cut-off wavelength of the infrared cut-off filter 320 can be extended, from 810nm to 900nm in this example. As a result, the amount of infrared light received by the infrared pixels is increased, which results in higher SNR. When the infrared image data is used to calculate depth information, this increased signal can also result in more accurate depth estimation.

For example, in one application, the multi-aperture system may be used to improve the depth of field (DOF) or other depth aspects of the camera. The DOF determines the range of distances from the camera that are in focus when the image is captured. Within this range the object is acceptably sharp. For moderate to large distances and a given image format, DOF is determined by the focal length of the imaging optics N, the f-number associated with the lens opening (the aperture), and/or the object-to-camera distance s. The wider the aperture (the more light received) the more limited the DOF. DOF aspects of a multi-aperture imaging system are illustrated in FIG. 4.

FIGS. 4A-4C depict operation of a multi-aperture imaging system according to one embodiment of the invention. Consider first FIG. 4B, which shows the imaging of an object 150 onto the image sensor 430. Visible and infrared light may enter the imaging system via the multi-aperture system 420. In one embodiment, the multi-aperture system 420 may be a filter-coated transparent substrate. One filter coating 424 may have a central circular hole of diameter D1. The filter coating 424 transmits visible light and reflects and/or absorbs infrared light. An opaque cover 422 has a larger circular opening with a diameter D2. The cover 422 does not transmit either visible or infrared light. It may be a thin-film coating which reflects both infrared and visible light or, alternatively, the cover may be part of an opaque holder for holding and positioning the substrate in the optical system. This way, the multi-aperture system 420 acts as a circular aperture of diameter D2 for visible light and as a circular aperture of smaller diameter D1 for infrared light. The visible light system has a larger aperture and faster f-number than the infrared light system. Visible and infrared light passing the aperture system are projected by the imaging optics 410 onto the image sensor 430.

The pixels of the image sensor may thus receive a wider-aperture optical image signal 452B for visible light, overlaying a second narrower-aperture optical image signal 454B for infrared light. The wider-aperture visible image signal 452B will have a shorter DOF, while the narrower-aperture infrared image signal 454 will have a longer DOF. In FIG. 4B, the object 150B is located at the plane of focus N, so that the corresponding image 160B is in focus at the image sensor 430.

Objects 150 close to the plane of focus N of the lens are projected onto the image sensor plane 430 with relatively small defocus blur. Objects away from the plane of focus N are projected onto image planes that are in front of or behind the image sensor 430. Thus, the image captured by the image sensor 430 is blurred. Because the visible light 452B has a faster f-number than the infrared light 454B, the visible image will blur more quickly than the infrared image as the object 150 moves away from the plane of focus N. This is shown by FIGS. 4A and 4C and by the blur diagrams at the right of each figure.

Most of FIG. 4B shows the propagation of rays from object 150B to the image sensor 430. The righthand side of FIG. 4B also includes a blur diagram 435, which shows the blurs resulting from imaging of visible light and of infrared light from an on-axis point 152 of the object. In FIG. 4B, the on-axis point 152 produces a visible blur 432B that is relatively small and also produces an infrared blur 434B that is also relatively small. That is because, in FIG. 4B, the object is in focus.

FIGS. 4A and 4C show the effects of defocus. In FIG. 4A, the object 150A is located to one side of the nominal plane of focus N. As a result, the corresponding image 160A is formed at a location in front of the image sensor 430. The light travels the additional distance to the image sensor 430, thus producing larger blur spots than in FIG. 4B. Because the visible light 452A is a faster f-number, it diverges more quickly and produces a larger blur spot 432A. The infrared light 454 is a slower f-number, so it produces a blur spot 434A that is not much larger than in FIG. 4B. If the f-number is slow enough, the infrared blur spot may be assumed to be constant size across the range of depths that are of interest.

FIG. 4C shows the same effect, but in the opposite direction. Here, the object 150C produces an image 160C that would fall behind the image sensor 430. The image sensor 430 captures the light before it reaches the actual image plane, resulting in blurring. The visible blur spot 432C is larger due to the faster f-number. The infrared blur spot 434C grows more slowly with defocus, due to the slower f-number.

The visible pixels capture visible light data and are used to create a conventional full-resolution color image. Infrared pixels capture infrared light data and are used to enhance the image's sharpness. Differences in sharpness between the two data sets are used to estimate the depth of objects in the image.

Examples of post-processing functions, including variations for calculating sharpness and/or depth, are described in U.S. Appl. No. 13/144,499, "Improving the depth of field in an imaging system"; U.S. Appl. No. 13/392,101, "Reducing noise in a color image"; U.S. Appl. No. 13/579,568, "Processing multi-aperture image data"; U.S. Appl. No. 13/579,569, "Processing multi-aperture image data"; and U.S. Appl. No. 13/810,227, "Flash system for multi-aperture imaging"; all of which are incorporated herein in their entirety.

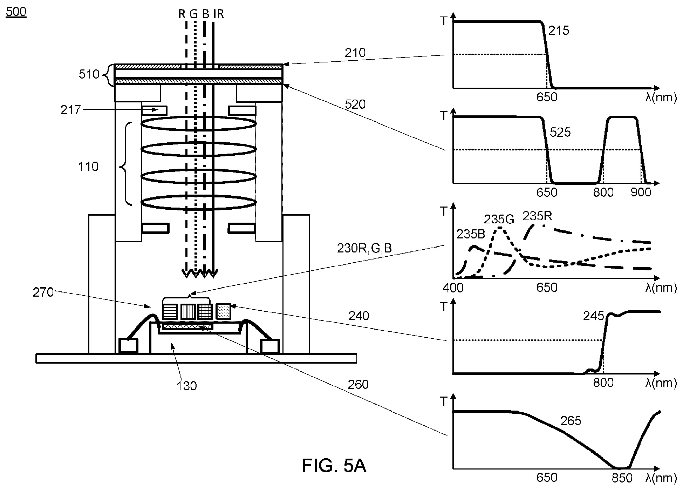

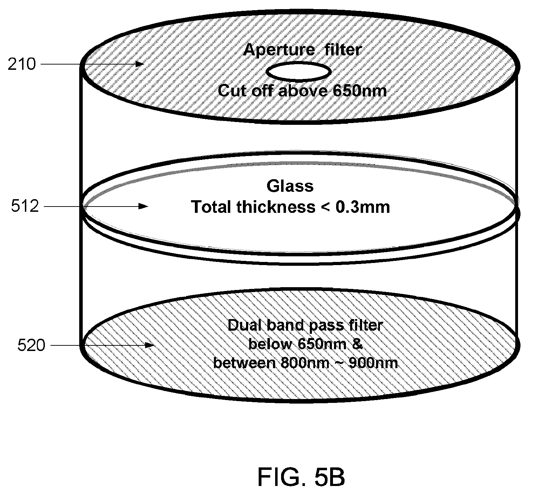

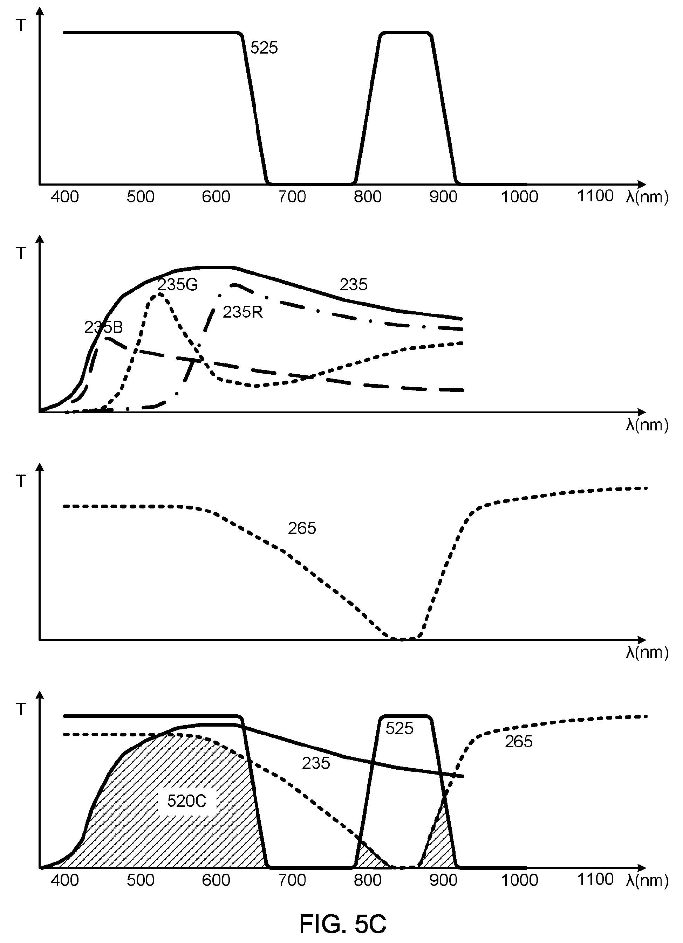

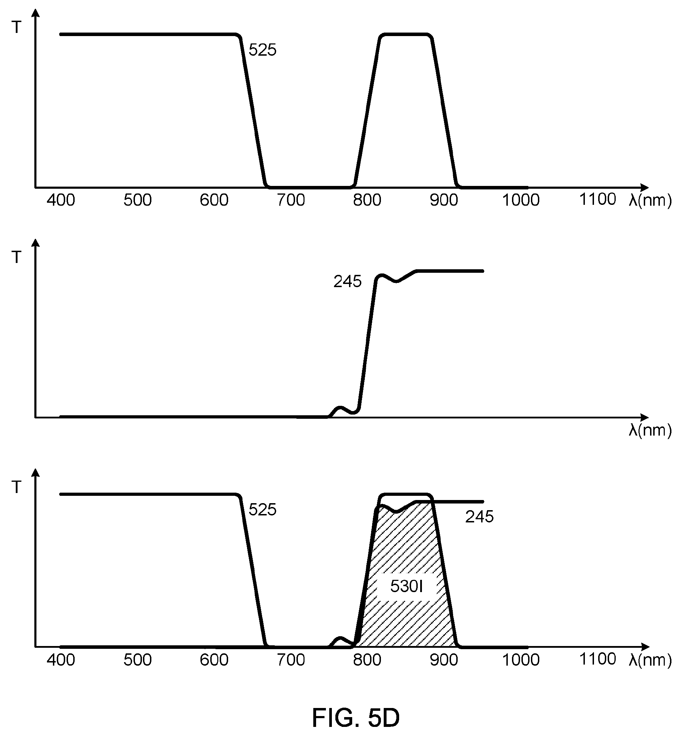

Referring to FIG. 1B, the multi-band filter 138 is designed to transmit visible and infrared light within separate wavelength bands. The infrared light passband of the multi-band filter 138 is designed to be localized within the passband of the infrared filter array 1321 and within the stopband of the visible filter array 132C. In this way, the transmitted infrared light from the multi-band filter 138 is suppressed on visible pixels, but is received by the infrared pixels. FIGS.5-7 give examples of the use of the sensor assembly integrated with the infrared filter array for imaging systems using a multi-band filter.

FIGS. 5A-5D illustrate an example. FIG. 5A is a cross-sectional diagram of a shared sensor imaging system 500 using a multi-band filter 520, instead of the infrared cut-off filters 220, 320 in FIGS. 2 and 3. The multi-band filter 520 has two passbands: one for wavelengths up to approximately 650nm and one for wavelengths from approximately 800nm-900nm. FIG. 5A also shows the spectral response 525 of this filter 520. Otherwise, the system 500 is the same as systems 200 and 300.

FIG. 5B is a diagram of one embodiment of the multi-band filter 520, which is integrated with the aperture filter 210 on opposite sides of a glass substrate 512. The aperture filter 210 is coated on the top side (incident light surface) of the glass substrate 512 and the multi-band filter 520 is coated on the bottom side of the glass substrate. The aperture filter 210 is the same as described previously. It has a center zone that transmits all wavelengths and an outer zone that filters out infrared wavelengths (e.g., with a cut-off wavelength of 650nm). The glass substrate 512 may be selected based on optical properties, e.g., absorption coefficient, refractive index, chromatic dispersion, relative permittivity and so forth. The total thickness of the glass substrate 512 preferably is 0.3 mm or less. The multi-band filter 520 includes two or more transparent filter coatings, created by depositing materials of varying indices. The spectral response 525 (shown in FIGS. 5A,C,D) shows the multi-band filter 520 transmits light within the visible and infrared bands but filters out light in a stopband between the visible and infrared passbands. In this example, the visible band is up to wavelength 650nm and infrared band is from 800nm to 900nm.

FIGS. 5C and 5D show the system's spectral responses. They are the same as in FIGS. 2 and 3, except the spectral response 225, 325 is replaced by spectral response 525. As seen in the bottom graph of FIG. 5C, the second passband for the multi-band filter 520 allows some leakage of infrared light onto the visible pixels 130R,G,B, but not much due to the good filter characteristics of the SIR filter 260. In addition, the multi-band filter 520 also reduces a large amount of the infrared crosstalk with wavelengths from 650nm-800nm.

As seen in the bottom graph of FIG. 5D, the multi-band filter 520 allows the infrared pixels 1301 to receive more infrared light within the wavelength band from 800nm-900nm, thus increasing the SNR for infrared signals.

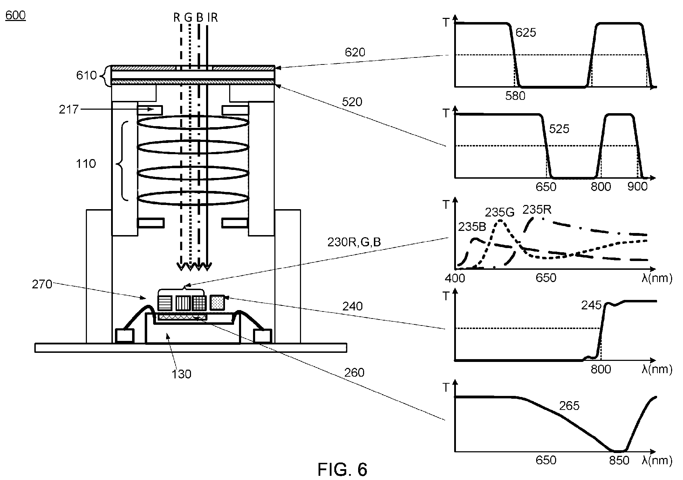

FIG. 6 illustrates another example use of a multi-band filter. In this example, red light, rather than infrared light, is used to obtain depth information. FIG. 6 is a cross-sectional diagram of a shared sensor imaging system 600 using an aperture filter 620. The system 600 is the same as the system 500, except the aperture filter 210 in FIG. 5 is replaced by aperture filter 620. The outer zone of aperture filter 620 has a spectral response 625 that transmits visible light up to approximately 580nm and filters out visible wavelengths above 580nm. The outer zone effectively filters out red light (wavelengths in a range of approximately 580-650nm), meaning the red light will only experience a smaller aperture defined by the center zone, rather than the larger full aperture. The filter 620 also passes the infrared wavelengths in the 800-900nm band.

Thus, the red light in FIG. 6 can play a similar role as the infrared light in FIG. 5A. The red (R) image will have a larger depth of field because it is exposed through a smaller aperture. The green (G), blue (B) and infrared (I) images will have a smaller depth of field because they are exposed through a larger aperture. The system 600 may be used for biometric (e.g. iris and face recognition) or other applications that use high-quality infrared and color images together with a depth map.

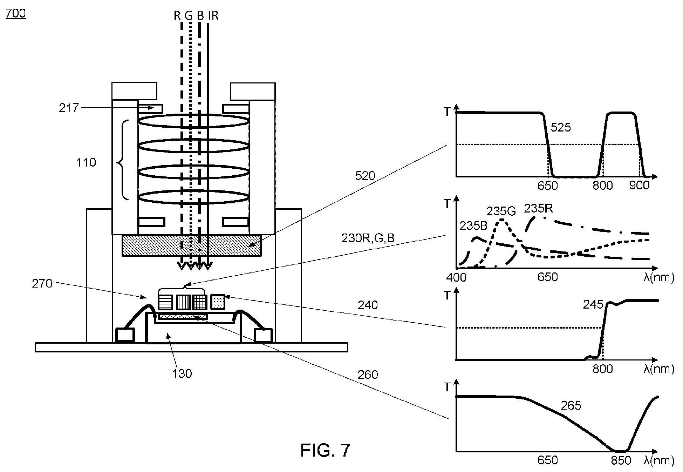

The application of sensor assembly integrated with SIR filter is not limited to a multi-aperture imaging system. It can also be used for other imaging systems or devices that capture both visible and infrared light, e.g., a camera that uses an IrED (Infrared Emitting Diode) to illuminate the object. FIG. 7 illustrates such an application. FIG. 7 is a cross-sectional diagram of an imaging system 700 for capturing visible and infrared light. The system 700 is the same as systems 500 and 600, except that the aperture filter 210, 620 is removed and the multi-band filter 520 is moved to a different location (although it could also remain in the same location as in FIGS. 6 and 7). Because there is no aperture filter, each of the R,G,B,I images is exposed through the same aperture. That is, system 700 captures an RGBI image. The R,G,B pixels are filtered by the color filter arrays 230 and the SIR filter array 260, which filter out the infrared wavelengths. The I pixels are filtered by the black filter array 240, which filters out the visible wavelengths. In an alternate design, the visible passband of the multi-band filter 525 may span approximately 400-650nm.

The image sensor with SIR filters (also referred to as a sensor assembly, or an image sensor with infrared/color filter array) is not limited to the embodiments discussed above. The image sensor with SIR filters can also be used for refocus or autofocus applications that use high-quality color images with a depth map. In embodiments where depth is estimated using blurred image, a clear infrared image may help increase the depth resolution. In embodiments where structured light is projected to measure the depth for gesture tracking, an infrared beam can be used without degrading a color image.

Moreover, the image sensor with SIR filters can be used for various applications, e.g., tablets, digital cameras (digital still camera, digital video camera, any other suitable digital camera that captures visible and infrared light), security system, gaming, gesture detection, PC multimedia, motion tracking, or any other suitable application, including those that use depth information, high frequency information, 3D information, motion information. Additionally, the image sensor with SIR filters also works under different types of illumination, e.g., direct sunlight, or any other suitable illumination that provides visible and infrared light.

Although the detailed description contains many specifics, these should not be construed as limiting the scope of the invention but merely as illustrating different examples and aspects of the invention. It should be appreciated that the scope of the invention includes other embodiments not discussed in detail above. For example, wavelength filtering can be achieved by many different means, including by absorbing or reflecting unwanted light, e.g., absorptive type filter or dichroic type filter. Filtering also is not required to reduce light levels to zero or to have a step-function like transition from transmitting to blocking, as can be seen from the various spectral responses in the figures. Moreover, the scope of the invention also is not limited to the specific wavelength schemes and aperture filters described in the above examples.

In addition, the scope of the invention also is not limited to the specific numbers given in the above examples. The infrared band may be determined by several factors, e.g., SNR, detection sensitivity, image quality, optical properties of illumination source (e.g., spectrum, intensity, absorption or scattering), short/long distance applications, and indoor/outdoor environment. For example, an 810nm infrared cut-off might be used for tracking gestures under direct, bright sunlight to capture color images with depth information. As another example, a 900nm infrared cut-off might be used for increasing sensitivity and SNR due to increased amount of detected infrared light. The infrared cut-off filter may be a shortpass filter, a bandpass filter, other suitable filter that filters out infrared light outside a predetermined infrared band, or combinations thereof. The visible or color band may be determined by color information required by the image sensor 130 for color reproduction. For example, the wavelength of the visible band may be up to 650nm, or up to 600nm.

Various other modifications, changes and variations which will be apparent to those skilled in the art may be made in the arrangement, operation and details of the method and apparatus of the present invention disclosed herein without departing from the spirit and scope of the invention as defined in the appended claims. Therefore, the scope of the invention should be determined by the appended claims and their legal equivalents.

## Claims

1. A sensor assembly comprising:
an image sensor comprising a plurality of visible pixels and infrared pixels, the visible pixels producing visible pixel signals indicative of light within a visible band received by the visible pixels and the infrared pixels producing infrared pixel signals indicative of light within an infrared band received by the infrared pixels; and
a selective infrared (SIR) filter array integrated on the image sensor, the SIR filter array comprising a plurality of SIR pixel filters positioned to filter out light within the infrared band propagating to the visible pixels.

2. The sensor assembly of claim 1 wherein the SIR pixel filter filters out infrared light up to a wavelength of at least 850 nm.

3. The sensor assembly of claim 1 wherein the infrared band is contiguous to the visible band and the infrared band includes infrared wavelengths up to approximately 810 nm.

4. The sensor assembly of claim 1 wherein the infrared band is contiguous to the visible band and the infrared band includes infrared wavelengths up to approximately 900 nm.

5. The sensor assembly of claim 1 wherein the infrared band is not contiguous to the visible band and the infrared band excludes infrared wavelengths lower than approximately 800 nm.

6. The sensor assembly of claim 1 wherein the visible band includes visible wavelengths up to approximately 650 nm, and the infrared band includes infrared wavelengths in a range of approximately 650-800 nm.

7. The sensor assembly of claim 1 wherein the visible band includes visible wavelengths up to approximately 650 nm, and the infrared band includes infrared wavelengths in a range of approximately 650-900 nm.

8. The sensor assembly of claim 1 wherein the visible band includes visible wavelengths up to approximately 650 nm, and the infrared band includes infrared wavelengths in a range of approximately 800-900 nm.

9. The sensor assembly of claim 1 further comprising a black filter array integrated on the image sensor, the black filter array comprising black pixel filters positioned to filter out light within the visible band transmitted to the infrared pixels.

10. The sensor assembly of claim 9 wherein the black pixel filter filters out visible light below 650 nm.

11. The sensor assembly of claim 9 wherein the black pixel filter filters out visible light below 800 nm.

12. The sensor assembly of claim 1 further comprising a color filter array integrated on the image sensor, the visible pixels comprising color pixels of at least two different color bands, the color pixels producing color pixel signals indicative of light within the color band for the color pixel, the color filter array comprising color pixel filters positioned to filter out light outside the color band for the color pixel.

13. The sensor assembly of claim 12 wherein the SIR filter array is located between the color filter array and the color pixels.

14. The sensor assembly of claim 12 wherein the color bands consist of a red color band, a green color band and a blue color band.

15. The sensor assembly of claim 1 wherein a pixel to pixel spacing is not greater than 4 µm.

16. The sensor assembly of claim 1 wherein the image sensor comprises at least 2 million pixels arranged in a rectangular array.

17. The sensor assembly of claim 1 wherein the visible pixel signals are combined to form color picture elements, and the image sensor comprises sufficient visible pixels to form at least 2 million color picture elements arranged in a rectangular array.

18. A visible+infrared imaging system comprising:
imaging optics that forms an image of an object; and
a sensor assembly positioned to capture the formed image, the sensor assembly comprising:
an image sensor, the image sensor comprising a plurality of visible pixels and infrared pixels, the visible pixels producing visible pixel signals indicative of light within a visible band received by the visible pixels and the infrared pixels producing infrared pixel signals indicative of light within an infrared band received by the infrared pixels; and
a selective infrared (SIR) filter array integrated on the image sensor, the SIR filter array comprising a plurality of SIR pixel filters positioned to filter out light within the infrared band transmitted to the visible pixels.

19. The visible+infrared imaging system of claim 18 wherein the infrared band is not contiguous to the visible band; and the dual-aperture system comprises a dual band cutoff filter that transmits light within the visible and infrared bands but filters out light between the visible and infrared bands.

20. The visible+infrared imaging system of claim 19 wherein the visible band includes visible wavelengths up to approximately 650 nm, and the infrared band includes infrared wavelengths in a range of approximately 800-900 nm.

21. The visible+infrared imaging system of claim 18 wherein the visible+infrared imaging system is a dual-aperture imaging system further comprising:
a dual-aperture system operating as a first aperture for the imaging optics for light within the visible band and operating as a second aperture for the imaging optics for light within the infrared band, the first aperture larger than the second aperture.

22. The visible+infrared imaging system of claim 21 wherein the dual-aperture system comprises a multi-zone wavelength filter having a first zone that filters out light within the infrared band from outside the second aperture, and a second zone that transmits light within the visible and infrared bands from within the second aperture.

23. The visible+infrared imaging system of claim 22 further comprising:
an IR cut-off filter that filters out infrared light at wavelengths greater than the infrared band.

24. The visible+infrared imaging system of claim 21 wherein the infrared band is not contiguous to the visible band; and the dual-aperture system comprises:
a multi-zone wavelength filter having a first zone that filters out light within the infrared band from outside the second aperture, and a second zone that transmits light within the visible and infrared bands from within the second aperture; and
a dual band cutoff filter that transmits light within the visible and infrared bands but filters out light between the visible and infrared bands.
